# Europäisches Patentamt

# European Patent Office

# Office européen des brevets

(19)

(11) Veröffentlichungsnummer: **0 001 574**
**B1**

(12)

# EUROPÄISCHE PATENTSCHRIFT

(45) Veröffentlichungstag der Patentschrift: **13.01.82**

(21) Anmeldenummer: **78101028.5**

(22) Anmeldetag: **29.09.78**

(51) Int. Cl.³: **H 01 L 27/08,**
**H 01 L 21/70, H 01 L 29/86**

(54) Halbleiteranordnung für Widerstandsstrukturen in hochintegrierten Schaltkreisen und Verfahren zur Herstellung dieser Halbleiteranordnung.

(30) Priorität: **25.10.77 US 844768**

(43) Veröffentlichungstag der Anmeldung:
**02.05.79 Patentblatt 79/9**

(45) Bekanntmachung des Hinweises auf die Patenterteilung:
**13.01.82 Patentblatt 82/2**

(84) Benannte Vertragsstaaten:
**BE DE FR GB**

(56) Entgegenhaltungen:
**US - A - 3 858 237**
**US - A - 3 966 577**
**US - A - 3 990 092**

(73) Patentinhaber: **International Business Machines Corporation**
**Armonk, N.Y. 10504 (US)**

(72) Erfinder: **Anantha, Narasipur Gundappa**
**1 Valdemar Road**
**Hopewell Junction, N.Y. 12533 (US)**
Erfinder: **Chang, Augustine Wei-Chun**
**19 Hill Top Drive**
**Wappingers Falls, N.Y. 12590 (US)**

(74) Vertreter: **Gaugel, Heinz, Dipl.-Ing.**
**Schönaicher Strasse 220**
**D-7030 Böblingen (DE)**

## Halbleiteranordnung für Widerstandsstrukturen in hochintegrierten Schaltkreisen und Verfahren zur Herstellung dieser Halbleiteranordnung

Die Erfindung betrifft eine Halbleiteranordnung für Widerstandsstrukturen entsprechend dem Oberbegriff des Patentanspruchs 1. Eine derartige Halbleiteranordnung ist in der US-Patentschrift 3 990 092 beschrieben. Ferner bezieht sich die Erfindung auf ein zugehöriges Verfahren zur Herstellung einer derartigen Halbleiteranordnung. Bevorzugt kann die Erfindung Anwendung finden im Zusammenhang mit dem Aufbau von integrierten Schaltkreisen auf der Grundlage des sog. Masterslice-Konzeptes, bei dem von einem möglichst universellen Schaltungsentwurf ausgegangen wird, und die Individualisierung der jeweils vorgesehenen Schaltungselemente, z. B. zu einem Widerstand oder Transistor, sowie deren Verdrahtung erst in einer möglichst späten Verfahrensstufe bei der Herstellung des integrierten Schaltkreises vorgenommen werden kann.

In der monolithisch integrierten Schaltkreistechnik besteht im allgemeinen die Notwendigkeit, die verschiedenen aktiven und passiven Bauelemente voneinander im Rahmen der integrierten Schaltung zu isolieren. Als mögliche Isolationstechniken kommen dafür die sog. aktive Isolation mittels gesperrter PN-Übergänge sowie die teilweise oder vollständige sog. passive bzw. dielektrische Isolation in Frage. Die zugehörigen dielektrischen Materialien waren dabei Siliciumdioxid, Glas usw. Bevorzugt wird im Rahmen der hochintegrierten Schaltungstechnik die dielektrische Isolation. Vorteilhaft ist dabei im wesentlichen gegenüber der aktiven Isolation, daß die Dotierungsgebiete der jeweiligen Schaltelemente direkt an die Isolationsgebiete anstoßen können, was in einer größeren Pakkungsdichte resultiert. Die Vorsehung einer dielektrischen Isolation reduziert die zugehörigen parasitären Kapazitäten und verbessert damit die Schaltgeschwindigkeit.

Zur Ausbildung einer dielektrischen Isolation werden heute üblicherweise Gräben bzw. Kanäle in einem Silicium-Halbleiterkörper gebildet und anschließend mit einem dielektrischen Material aufgefüllt. Die chemische Ätzung solcher Gräben als eine Möglichkeit ist beispielsweise näher beschrieben in den US-Patentschriften 3 970 486, 3 534 234 und 3 648 125. Eine weitere Möglichkeit zur Grabenbildung besteht in der selektiven Bildung einer Epitaxieschicht mit Gräben oder Öffnungen darin und ist näher beschrieben in der US-Patentschrift 3 386 865 sowie in dem Aufsatz "A Composite Insulator-Junction Isolation" von R. E. Jones u.a. in der Zeitschrift "Electrochemical Technology", Band 5, Nr. 5—6, Mai-Juni 1967, Seiten 308 bis 310. Schließlich besteht zur Bildung der Gräben die Möglichkeit der reaktiven Ionenätzung (Plastmaätzung). Eine nähere Beschreibung dieser Technik findet sich beispielsweise in den US-Patentschriften 3 966 577 und 3 997 378 sowie in der Veröffentlichung im IBM Technical Disclosure Bulletin, Band 20, Nr. 1, Juni 1977, Seiten 144/145.

In jedem Fall liegen demnach nach Vorsehung der Isolation gegeneinander isolierte Siliciumbereiche im Halbleiterkörper vor. In diesen einkristallinen isolierten Siliciumbereichen werden dann aktive Schaltelemente, z. B. Bipolartransistoren, Feldeffekttransistoren sowie passive Bauelemente wie Widerstände, Dioden usw., hergestellt. Die wesentlichen Schritte im Rahmen der Herstellung derartiger integrierter Schaltungselemente können als allgemeiner Stand der Technik vorausgesetzt werden. An dieser Stelle wird deshalb nur eine kurze Übersichtsdarstellung dazu gegeben.

Man geht beispielsweise von einem P-leitenden Siliciumsubstrat aus, oxidiert dessen Oberfläche, öffnet in der Oxidschicht mittels konventioneller Photolithographie- und Ätzverfahren Maskenfenster für die anschließende Eindotierung, z. B. Diffusion, eines $N^+$-leitenden vergrabenen Bereichs, der später den Subkollektor darstellen wird. Anschließend wird die Siliciumdioxidschicht entfernt und man läßt eine Epitaxieschicht aus N-leitendem Silicium auf der freigelegten Halbleiteroberfläche aufwachsen. Während des Wachstums der Epitaxieschicht erfolgt eine gewisse Ausdiffusion des vergrabenen Bereiches in die Epitaxieschicht hinein. Auf die Oberfläche der so gebildeten Epitaxieschicht wird dann erneut eine Siliciumdioxidschicht aufgebracht, in der wiederum Maskenöffnungen für die Isolationsdiffusion bzw. die dielektrischen Isolationsgebiete hergestellt werden. Nach deren Herstellung werden erneut Dotierungsöffnungen in der Siliciumdioxidschicht für die Basisdotierung geöffnet, was im Falle eines NPN-Transistors oder eines Widerstandsbereiches durch Eindotierung von P-leitenden Dotierungsstoffen in die Epitaxieschicht erfolgt. Die Halbleiteroberfläche wird danach jeweils reoxidiert, worauf anschließend in gleicher Weise die Verfahrensschritte zur Ausbildung der Emitter sowie der Kollektoranschlußgebiete durchgeführt werden. Daran schließen sich die Ausbildung der ohmschen Anschlußkontakte sowie der Metallisierung für die Verbindungsleiterzüge an, die beispielsweise aus Aluminium hergestellt werden.

Im Rahmen der Integrierten Schaltkretisherstellung sind diffundierte Widerstände allgemein üblich, sie werden jedoch normalerweise mit der Basisdiffusion einer Bipolartransistorstruktur hergestellt. Insoweit kann auf die obigen Ausführungen sowie auf die US-Patentschriften 3 990 092, 3 591 430, 3 772 097, 3 700 977 und 3 959 040 verwiesen werden. Dieser Widerstandstyp zeigt jedoch Nachteile, wenn man zu höheren Packungsdichten bei integrierten Schaltkreisen kommen möchte. Einer der Nachteile besteht darin, daß die Diffusionstiefe so groß sein muß, daß darin eine weitere Dotierung vom entgegengesetzten Leitungstyp, z. B. für den Emitter, vorgenommen werden kann. Für die Ausbildung des Basisgebiets wird ferner normalerweise eine Dotierungskonzentration von etwa $10^{18}$ Atomen/cm³ verlangt. Hochwertige Widerstände können bei Dotierungspegein dieser Höhe nicht gemacht werden. Dieser Widerstandstyp ist demnach nicht geeignet für hochdotierte integrierte Schaltungen mit sehr niedriger Verlustleistung.

Es wurden aber auch bereits Widerstandsstrukturen in der N-leitenden Epitaxieschicht gebildet, vgl. z. B. die US-Patentschrift 3 860 836. Dort ist der Widerstand von den übrigen Bauelementen durch einen PN-Übergang isoliert. Nachteile weist diese Widerstandsstruktur insbesondere dann auf, wenn man N-leitende Epitaxiewiderstände mit hohen Widerstandswerten in einer hochintegrierten Struktur vorsehen will Infolge des Selbstdotierungs- bzw. Ausdiffusionseffektes aus benachbarten (N$^+$- oder P$^+$-leitenden) Dotierungsgebieten wird die N-leitende Epitaxieschicht beim Aufwachsvorgang verändert. Im Ergebnis lassen sich damit nur recht unbefriedigende Toleranzwerte für den Schichtwiderstand (gewöhnlich) ±40%) erreichen. Ferner ist die Epitaxieschicht notwendigerweise relativ dick, weil darin üblicherweise eine Transistorstruktur auszubilden sein wird. Von daher kann selbst ohne Berücksichtigung des Selbstdotierungseffektes der Schichtwiderstand keine hohen Werte annehmen.

Als weitere Literaturstellen für in isolierten Gebienten eines Halbleiterkörpers durch Diffusion oder lonenimplantation hergestellte Dotierungsgebiete mit diversen Leitungstypen seien für den Fall einer Isolation mittels gesperrter Halbleiterübergänge noch die US-Patentschriften 3 703 420 und 3 982 266 sowie für mittels dielektrischer Gebiete isolierter Halbleiterbereiche die US-Patentschriften 3 919 005 und 3 954 523 genannt.

Die Erfindung, wie sie in den Patentansprüchen gekennzeichnet ist, löst die Aufgabe, Halbleiteranordnungen für Widerstandsstrukturen enthaltende hochintegrierte Schaltkreise anzugeben, mit denen hochwertige und mit engen Toleranzwerten für die Schichwiderstandswerte ausgestattete Widerstandselemente vorgesehen werden können.

Die Erfindung wird im folgenden an Hand von Ausführungsbeispielen unter Zuhilfenahme der Zeichnungen näher erläutert.

Es zeigen:
Fig. 1 bis 4 den sich in verschiedenen Verfahrensstufen ergebenden Strukturaufbau einer Widerstandsstruktur nach einem Ausführungsbeispiel der Erfindung;
Fig. 5 und 6 ein zweites Ausführungsbeispiel für eine resultierende Widerstandsstruktur nach der Erfindung;
Fign. 7 und 8 Ersatzschalbilder für die in den Fign. 5 und 6 gezeigten Widerstandstrukturen;
Fig. 9 ein drittes Ausführungsbeispiel im Rahmen der Erfindung und
Fig. 10 ein zur Struktur von Fig. 9 gehöriges elektrisches Ersatzschaltbild.

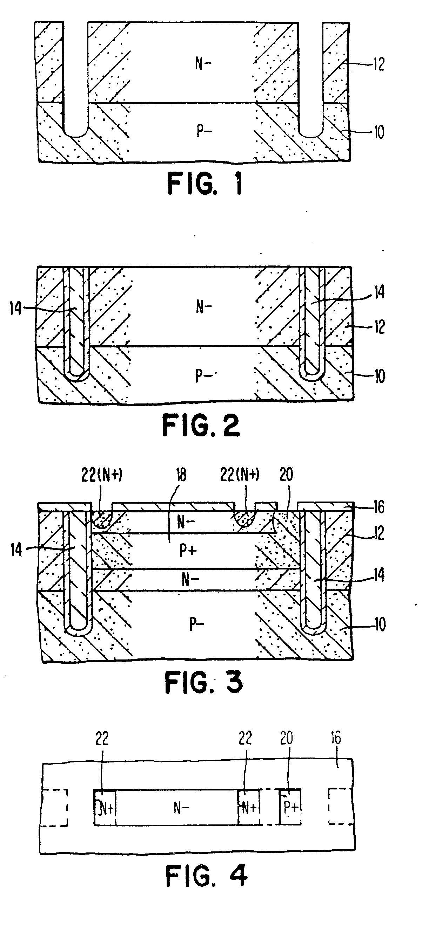

Die für ein erstes Ausführungsbeispiel der Erfindung an Hand der Fign. 1 bis 4 veranschaulichte Folge von Herstellungsschritten geht von einem Wafer bzw. Substrat 10 aus P-leiten-dem einkristallinem Silicium aus. Ein solches Substrat 10 kann beispielsweise durch Ziehen eines einkristallinen Stabes aus einer geeigneten Schmelze erhalten werden, die ein P-leitendes Material, z. B. Bor, enthält und bei dem ein Keimkristall mit einer kristallographischen <100>-Orientierung eingesetzt wird. Der daraus resultierende Stab wird anschließend in sehr dünne Scheiben (Wafer) geschnitten, die ihrerseits wiederum die genannte kristallographische Orientierung hinsichtlich ihrer Oberfläche aufweisen. Ein solches P-leitendes Siliciumsubstrat weist vorzugsweise einen spezifischen Widerstand von etwa 10 bis 20 Ωcm auf.

Um auf der Oberfläche des Substrats 10 eine Epitaxieschicht 12 aufwachsen zu lassen, wird die Anordnung darauf in eine entsprechende Apparatur eingesetzt. Die Epitaxieschicht kann in jeder gewünschten Dicke hergestellt werden, wobei jedoch im Rahmen der in vorliegender Erfindung angestrebten Hochgeschwindigkeits-Bauelemente die Dicke kleiner als etwa 2 $\mu$m sein sollte. Die bevorzugte Dicke der Epitaxieschicht ist etwa 1,2 um. Die Epitaxieschicht 12 läßt man auf dem Substrat 10 mittels konventioneller Verfahrensschritte aufwachsen, z. B. unter Verwendung von Mischungen aus $SiCl_4/H_2$ oder $SiH_4/H_2$ bei etwa 1000 bis 1200°C.

Die nächsten Verfahrensschritte dienen zum Ätzen der Siliciumstruktur mittels sog. reaktiver lonenätzung bzw. Plasmaätzung. Dazu wird zunächst in konventioneller Weise entweder thermisch bei einer Temperatur von 970°C in nasser oder trockener Sauerstoffatmosphäre oder durch chemische Niederschlagsverfahren eine (nicht dargestellte) Siliciumdioxidschicht ausgebildet. Es können auch andere Materialien für die Maskierungsschicht benutzt werden, z. B Siliciumnitrid und Aluminiumoxid oder Mischformen daraus. Bevorzugt wird eine 100 bis 300 nm dicke Siliciumdioxidschicht, die mittels chemischer Niederschlagung aus der Gasphase unter Verwendung einer Mischung aus Silan und $N_2O$ bei 800°C in einer Stickstoffatmosphäre gebildet wird. Mittels konventioneller Photolithographie- und Ätzverfahren werden dann in der Siliciumdioxidschicht geeignete Öffnungen an den Stellen gebildet, an denen die Isolationsgebiete vorgesehen werden sollen. Die Anordnung wird dann in eine Einrichtung zum reaktiven Ionenätzen eingebracht und dort behandelt. Bezüglich weiterer Einzelheiten dieses reaktiven Ionenätzens wird auf die am 9. Juli 1975 in den USA eingereichte Patentanmeldung "Reactive Ion Etching of Silicon" der Erfinder J. N. Harvilchuck et al mit dem Aktenzeichen 594 418 entsprechend der deutschen Patentanmeldung P 26 17 483 Bezug genommen. Das HF-Plasma besteht aus reaktives Chlor, Brom oder Jod enthaltendem Material. Die Dicke der Maskierschicht liegt zwischen etwa 200 bis 2000 nm, wobei die exakte Dicke jeweils von der Tiefenerstreckung der Ätzgrube im Silicium abhängt. In der genannten Patentanmeldung findet sich auch eine genaue Beschreibung der HF-Entladeapparatur. Die Plasmaatmosphäre ist vorzugsweise eine Kombination aus einem Edelgas, z. B. Argon, und einem Fluor enthaltenden Material. Die zugeführte Leistung zur Erzielung einer für Silicium ausreichenden Ätzrate liegt bei etwa 0,1 bis 0,75 W/cm² und wird von einer HF-Spannungsquelle geliefert. Das erstrebte Ergebnis dieses Ätzvorganges ist eine Offnung bzw. ein Kanal, die bis in den P-leitenden Grundkörper 10 hineinreicht. Die resultierende Struktur zeigt Fig. 1.

Der nächste Schritt in dem hier behandelten Verfahrensablauf besteht in der thermischen Oxidation der so gebildeten Öffnungen oder Kanäle, indem man den Halbleiterkörper beispielsweise bei 970°C einer nassen Sauerstoffatmosphäre aussetzt. Um innerhalb der Öffnung bzw. des Kanals die Siliciumdioxidschicht mit einer bevorzugten Dicke von 50 bis 200 nm auszubilden, beträgt die Behandlungsdauer etwa 10 bis 30 Min. Durch das thermisch gebildete Oxid sollen gute Grenzflächeneigenschaften des Siliciumdioxids gewährleistet werden, was gewöhnlich mit chemisch niedergeschlagenem dielektrischen Material nicht befriedigend genug erreicht wird. Die Bildung des dielektrischen Materials mit hoher Qualität ist auf der anderen Seite deshalb nötig, um ein direktes Angrenzen der Diffusionsübergänge bzw. der Dotierungsgebiete an die dielektrischen Isolationsgebiete zulassen zu können. Die letztlich erfolgende vollständige Auffüllung der Öffnung mit einem geeigneten dielektrischen Material wird mittels Niederschlags von Siliciumdioxid vorgenommen.

In manchen Fällen kann es von Vorteil sein, vor dem pyrolythischen Niederschlagen eine Ionenimplantation von Borionen durch die den Boden der Isolationsgräben bedeckende Oxidschicht vorzunehmen. Dadurch werden unterhalb der Isolationsgebiete P⁺-dotierte Gebiete erzeugt, wodurch eine Inversion des P⁻-Materials unterhalb der Isolationsgebiete in N-leiten-des Material verhindert wird.

Das pyrolythische Siliciumdioxid wird mit einer vorzugsweisen Dicke von 2 bis 3 $\mu$m niedergeschlagen. Der bevorzugte Auffüllprozeß besteht in einem chemischen Niederschlagen von Siliciumdioxid aus der Gasphase unter Verwendung von Gasgemischen aus $CO_2/SiH_4/N_4$ oder $N_2O/SiH_4/N_2$ im Temperaturbereich zwischen 800 und 1000°C. Die typische Niederschlagsrate liegt dabei etwa in der Größenordnung von 5 bis 10 pm pro Min. Als nächster Verfahrensschritt folgt das Beseitigen des überschüssigen Siliciumdioxids von der Oberfläche mittels reaktiver Ionenstzung. Die dazu verwendbare Einrichtung würde aus einer Apparatur von Niederdruck-Sputtertyp bestehen, in der die Wafer auf einer die Kathode darstellenden Deckplatte aus Silicium angeordnet sind. Als Ätzmittel würde ein fluorierter Kohlenwasserstoff, z. B. $CF_4$, benutzt wenden, so daß ein $SiO_2/Si$-Verhältnis von ungefähr 1:1 resultiert. Der Gasdruck würde etwa von 10 bis 70 $\mu$m betragen mit Gasdurchflußraten von 2 bis 50 cm³/Min. Die HF-Leistung würde ab etwa 0,1 W/cm² betragen.

In Fig. 2 ist die vollständige Isolation der gewünschten einkristallinen Siliciumgebiete mittels dielektrischer Isolationgebiete 14 dargestellt. Die Halbleiteroberfläche wird anschließend reoxidiert, indem man 0,1 bis 0,2 $\mu$m thermisches Siliciumdioxid aufwachsen läßt, um die Siliciumdioxidschicht 16 auf die gewünschte Dicke zu bringen.

Entsprechend Fig. 3 wird dann die vergrabene Implantation für die PN-Isolation des Widerstands vorgenommen. Mittels üblicher Photolithographie- und Ätztechniken erfolgt die Ausbildung eines entsprechenden Photolackmusters, wobei die Stellen der Photolackschicht entfernt werden, an denen die P⁺-Ionenimplantation durchgeführt werden soll. Die gesamte Anordnung wird dann in eine geeignete Ionenimplantationseinrichtung eingesetzt, in der eine Bor-Implantation bei 200 bis 500 keV und einer Dosis von $5 \times 10^{14}$ Atomen/cm² vorgenommen wird. Anzumerken ist in diesem Zusammenhang, daß eine dünne Siliciumoxidschicht von etwa 25 bis 30 nm auf der Halbleiteroberfläche belassen wird, um eine nützliche Schirmwirkung für die Ionenimplantation zu erfüllen. Das Ergebnis dieses Verfahrensschritts ist das vergrabene, P-leitende Gebiet 18. Das zu diesem Gebiet 18 hindurchreichende Anschlußgebiet wird ebenfalls in konventioneller Weise durch Photolithographie- und Ätzschritte in einer den Halbleiterkörper bedeckenden Maskenschicht abgegrenzt. In einer Ionenimplantationseinrichtung erfolgt dann die entsprechende Implantation von Bor bei 150 keV mit einer Dosis von $5 \times 10^{12}$ Atomen/cm². Daran schließt sich ein Hochtemperaturschritt zum Ausheilen an. Bezüglich der Halbleiteranordnung ist somit durch das Anschlußgebiet die Verbindung von der Oberfläche zum vergrabenen P-leitenden Gebiet 18 hergestellt.

Nach einer erneuten Reoxidation werden in der die Oberfläche bedeckenden Oxidschicht die Öffnungen für die Diffusions- oder Implantationsschritte hergestellt, mit denen die Kontakt- bzw. Anschlußgebiete für den Widerstand ausgebildet werden. Im Anschluß an die zugehörigen konventionellen Photolithographie- und Ätzschritte wird die Anordnung dazu beispielsweise in eine Implantationseinrichtung eingesetzt, in der Phosphor- oder Arsenionen mit einer Dosis von $10^{15}$ Atomen/cm$^2$ bei etwa 200 keV zur Erzielung der Dotierungsgebiete 22 implantiert werden. Anschließend erfolgt eine Wärmebehandlung bei 1000°C über etwa 10 bis 20 Min. in einer Schutzgasatmosphäre, um die bei der Ionenimplantation hervogerufenen (Kristall-)Schäden zu beseitigen und die eingebrachten Verunreinigungsatome (elektrisch) zu aktivieren. Nach dem Herstellen einer Kontaktöffnung zum P$^+$-Gebiet 20 ergibt sich somit die in Fig. 3 im Querschnitt bzw. in Fig. 4 der Draufsicht dargestellte Struktur.

Auf die Oberfläche wird dann ein geeignetes Metall für die ohmschen Kontakte aufgedampft oder in anderer Weise aufgebracht. Ein typisches Kontaktmaterial ist Aluminium oder Aluminium-Kupfer. Es können aber auch andere in diesem Zusammenhang als geeignet bekannte Materialien verwendet werden, z. B. Platin, Palladium, Molybdän usw. Die Ausbildung des jeweiligen Leiterzug- oder Verbindungsmusters in der Metallisierungsebene erfolgt ebenfalls wieder mittels bekannter Photolithographie- und Ätztechniken.

Zur Erzielung einer möglichst hohen integrierten Packungsdichte ist es vorzuziehen, daß sowohl das eine (linke) Anschlußgebiet 22 des Widerstandes sowie das Anschlußgebiet 20 jeweils direkt an das benachbarte dielektrische Isolationsgebiet angrenzt.

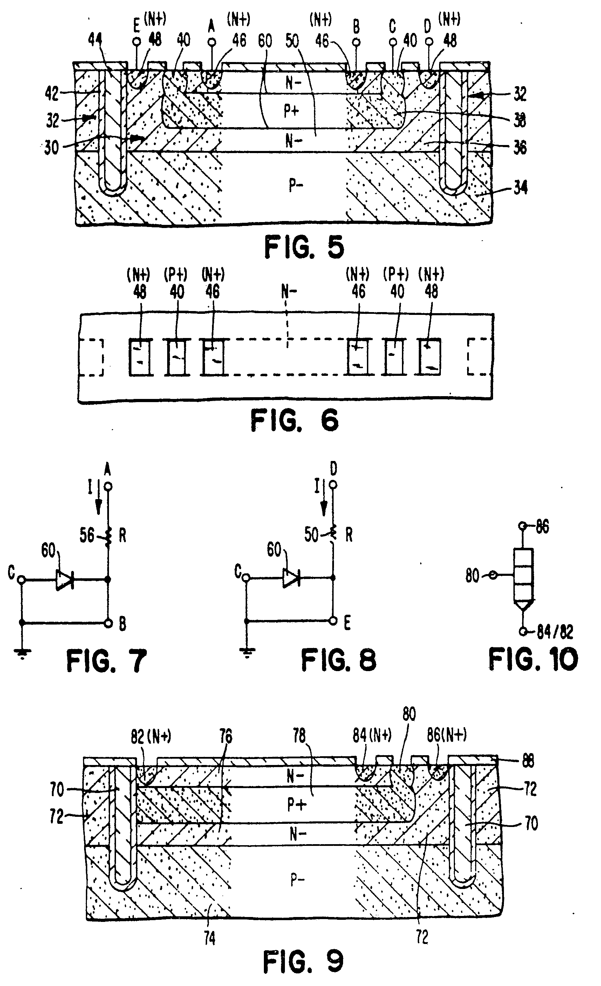

In den Figuren 5 und 6 ist ein zweites Ausführungsbeispiel illustriert, bei dem zwei Widerstandselemente in einem einzigen dielektrisch isolierten einkristallinen Siliciumbereich angeordnet sind. Das in Fig. 5 mit 30 bezeichnete Siliciumgebiet ist von benachbarten Gebieten gleicher Art durch eine das gesamte Gebiet umgebende dielektrische Barriere 32 isoliert. Jedes dieser Siliciumgebiete 30 umfaßt ein Gebiet 34 vom Grundkörper eines ersten Leitungstyps, ein zweites Gebiet 36 vom zweiten Leitungstyp, ein drittes Gebiet 38 vom ersten Leitungstyp innerhalb des zweiten Gebietes 36 sowie ein Anschlußgebiet 40 vom ersten Leitungstyp, das eine Verbindung von der Oberfläche zum dritten Gebiet 38 herstellt. Die dielektrische Barriere 32 ist vorzugsweise aus mindestens einer äußeren Schicht 42 aus thermisch aufgewachsenem Siliciumdioxid und einer inneren Schicht aus pyrolithischem Siliciumdioxid zusammengesetzt. In Fig. 5 ist der erste Leitungstyp mit P und der zweite Leitungstyp mit N angenommen, so daß ein N-Typ-Widerstand vorliegt. Die N$^+$-Anschlußgebiete für den an der Oberfläche liegenden Widerstand sind mit 46 bezeichnet. Die N$^+$-Anschlußgebiete für das vergrabene Widerstandselement sind mit 48 bezeichnet. Die zugehörige Draufsicht auf diese Ausführungsform zeigt Fig. 6.

Die in den Figuren 5 und 6 gezeigte Ausführungsform kann mittels derselben Prozeßschritte hergestellt werden, wie oben an Hand der Figuren 1 bis 4 ausgeführt worden ist. In diesem Fall ist jedoch zusätzlicher Platz zwischen dem Isolationsgebiet 32 und dem vergrabenen P$^+$-Gebiet 38 mit seinen Anschlußgebieten 40 vorzusehen, um die Anschlußgebiete 48 für das zweite Widerstandselement unterbringen zu können.

In den Figuren 7 und 8 ist das elektrische Ersatzschaltbild der in den Figuren 5 und 6 gezeigten Halbleiteranordnung gezeigt. Der in Fig. 5 an der Oberfläche angeordnete Widerstand ist in Fig. 7 mit 56 bezeichnet; seine Anschlüsse sind entsprechend A, B und C. Die Diode 60 repräsentiert den PN-Übergang zwischen den Gebieten 38 und 50. Fig. 8 ist das Ersatzschaltbild für das vergrabene Widerstandselement 50 zwischen den Anschlüssen D und E. Auch hier repräsentiert die Diode 60 den isolierenden PN-Übergang zwischen den Gebieten 38 und 40 einerseits und dem Widerstandsgebiet 50 andererseits.

In Fig. 9 ist ein drittes Ausführungsbeispiel gezeigt, mit dem die Möglichkeit einer Personalisierung nach Art eines Master-slice-Konzepts verdeutlicht werden soll. Ein Muster dielektrischer Umrahmungsgebiete 70 grenzt einzelne einkristalline Siliciumbereiche 72 im Halbleiterkörper voneinander ab. Diese isolierten Siliciumgebiete enthalten jeweils ein Substrat 74 vom ersten Leitungstyp, z. B. P, sowie ein darüber angeordnetes Gebiet 74 vom zweiten Leitungstyp. Dieses Zweite Gebiet wird in typischen Fällen durch eine Epitaxieschicht dargestellt. Als vergrabenes Gebiet ist in dem Gebiet 76 vom zweiten Leitungstyp ein Gebiet 78 vom ersten Leitungstyp angeordnet. Dieses Gebiet 78 wird vorzugsweise mittels Ionenimplantation in der oben im Zusammenhang mit den Fign. 1 bis 4 beschriebenen Weise hergestellt. Ein Anschlußgebiet 80 stellt eine Verbindung des vergrabenen Gebiets 78 mit der Oberfläche her. Dieses Anschlußgebiet wird mittels Diffusion oder Ionenimplantation erzeugt. Dotierstoffe vom zweiten Leitungstyp, z. B. N$^+$, werden schließlich eingebracht, um die Anschlußgebiete 82 und 84 für den an der Oberfläche liegenden Widerstand sowie ein Anschlußgebiet für das N-Gebiet 76 unterhalb des P$^+$-Gebiets 78 herzustellen. In dieger Verfahrensstufe kann nun wahlweise eine Personalisierung der Halbleiteranordnung derart vorgenommen werden, daß man entweder einen Widerstand unter Benutzung der Kontaktgebiete 82 und 84 bildet oder daß man einen Transistor unter Benutzung des Kontaktgebiets 84 als Emitter, des Kontaktgebiets 86 für die Basis und schließlich des Kontaktgebiets 86 als Kollektor herstellt. Im Falle einer gewünschten Widerstandsstruktur würde die Siliciumdioxidschicht 88 das Gebiet 86 bedecken und zu diesem Teil des Siliciumgebiets würde kein Metallkontakt hergestellt werden.

Für den Fall einer gewünschten Transistorstruktur würde bei einer Anordnung entsprechend Fig. 9 die Siliciumdioxidschicht 88 eines der Widerstandskontaktgebiete, z. B. 82, bedecken. In diesem Bereich würde dann kein ohmscher Kontakt vorgesehen. Fig. 10 zeigt das entsprechende elektrische Ersatzschaltbild mit 86 als Kollektor-, 80 als Basis- und 84 (bzw. 82) als Emitteranschlußgebiet.

**Patentansprüche**

1. Halbleiteranordnung für Widerstandsstrukturen in hochintegrierten Schaltkreisen mit einem Silicium-Halbleitkörper (10, 12), in dem durch Umrahmungsgebiete (14, 44, 70) einzelne gegeneinander isolierte Halbleiterbereiche für die Aufnahme von Schaltungselementen abgegrenzt sind, ferner mit einem an der Oberfläche eines derart abgegrenzten Halbleiterbereichs liegenden und mit Anschlüssen ausgestatteten, die Widerstandsstruktur darstellenden ersten Gebiet eines ersten Leitungstyps, unter dem ein zweites Halbleitergebiet (18, 38, 78) vom dazu entgegengesetzten zweiten Leitungstyp angeordnet ist, zu dem von der Halbleiteroberfläche eine elektrische Verbindung über ein drittes Halbleitergebiet (20, 40, 80) vom zweiten Leitungstyp vorgesehen ist, dadurch gekennzeichnet, daß es sich bei den Umrahmungsgebieten (14, 44, ·70) um Gebiete aus dielektrischem Material und bei dem zweiten Halbleitergebiet (18, 38, 78) um ein vergrabenes und relative zum ersten Gebiet hochdotiertes Halbleitergebiet handelt.

2. Halbleiteranordnung nach Anspruch 1, dadurch gekennzeichnet, daß die dielektrischen Umrahmungsgebiete (14, 44, 70) zumindest eine äußere Schicht aus thermisch gebildetem Siliciumdioxid (z. B. 42 in Fig. 5) enthalten.

3. Halbleiteranordnung nach Anspruch 1 oder 2, dadurch gekennzeichnet, daß seitlich angrenzend an das dielektrische Umrahmungsgebiet (14) im ersten Halbleitergebiet vom ersten Leitungstyp eines der demgegenüber höherdotierten Anschlußgebiete (22) für die Widerstandsstruktur angeordnet ist und das dritte Halbleitgebiet (20) für die Verbindung von der Oberfläche zum vergrabenen zweiten Halbleitergebiet (18) auf der gegenüberliegenden Seite an das dielektrische Umrahmungsgebiet seitlich angrenzend ausgebildet ist (Fign. 3, 4).

4. Halbleiteranordnung nach Anspruch 1 oder 2, gekennzeichnet durch eine innerhalb eines abgegrenzten Halbleiterbereichs vorgesehene zweite Widerstandsstruktur in dem unterhalb des zweiten Halbleitergebiets (38) vorhandenen Halbleitermaterial vom ersten Leitungstyp, deren elektrische Verbindung zur Halbleiteroberfläche über seitlich dazu angeordnete Halbleitermaterialzonen vom ersten Leitungstyp erfolgt (Fig. 5).

5. Halbleiteranordnung nach Anspruch 4, dadurch gekennzeichnet, daß an gegenüberliegenden Seiten eines dielektrischen Umrahmungsgebiets (44) seitlich angrenzend je eines der höherdotierten Anschlußgebiete (48) vom ersten Leitungstyp für die zweite Widerstandsstrucktur angeordnet ist.

6. Halbleiteranordnung nach mindestens einem der vorhergehenden Ansprüche, dadurch gekennzeichnet, daß die in verschiedenen isolierten Halbleiterbereichen vorgesehenen Gebietsanordnungen wahlweise je als Widerstands- und/oder Transistorstrukturen anschließar sind.

7. Halbleiteranordnung nach Anspruch 6, dadurch gekennzeichnet, daß die Halbleitergebiete für die erste und zweite Widerstandsstruktur das Emitter- bzw. Kollektorgebiet einer Transistorstruktur mit dem dazwischenliegenden vergrabenen zweiten Gebiet als Basisgebiet daistellen (Fign. 9, 10).

8. Verfahren zur Herstellung einer Halbleiteranordnung nach mindestens einem der vorhergehenden Ansprüche, bei dem in einem Silicium-Halbleiterkörper (10, 12) durch dielektrische Umrahmungsgebiete (14, 44, 70) isolierte Halbleiterbereiche für die Aufnahme von Schaltungselementen abgegrenzt werden, gekennzeichnet durch die folgenden Verfahrensschritte:

— in einem sich bis an die Oberfläche des Halbleiterkörpers erstreckenden ersten Gebiet aus Halbleitermaterial vom ersten Leitungstyp wird ein demgegenüber höherdotiertes vergrabenes zweites Halbleitergebiet (18, 38, 78) vom dazu entgegengesetzten zweiten Leitungstyp ausgebildet,

— an mindestens einer Seite des vergrabenen zweiten Halbleitergebiets wird ein, eine elektrische Verbindung von der Halbleiteroberfläche zum zweiten Halbleitergebiet herstellendes drittes Halbleitergebiet (20, 40, 80) vom zweiten Leitungstyp vorgesehen und

— in dem ersten und dritten Halbleitergebiet werden an die Umrahmungsgebiete angrenzende Anschlußgebiete bzw. Kontakte für die externen Schaltungsverbindungen hergestellt.

9. Verfahren nach Anspruch 8, dadurch gekennzeichnet, daß das zweite Halbleitergebiet mit dem seitlich daran vorgesehenen und bis zur Halbleiteroberfläche reichenden dritten Halbleitergebiet das erste Halbleitergebiet seitlich und nach unten vollständig umschließend ausgebildet wird und daß das seitlich und untenhalb des zweiten und dritten Halbleitergebiets bis zu den Umrahmungsgebieten verbleibende Halbleitermaterial vom ersten Leitungstyp durch Vorsehung von die Verbindung zur Halbleiteroberfläche herstellenden Dotierungsgebieten vom gleichen Leitungstyp als eine vergrabene zweite Widerstandsstruktur im gleichen isolierten Halbleiterbereich ausgebildet wird.

10. Verfahren nach Anspruch 8 oder 9, dadurch gekennzeichnet, daß insbesondere das zweite Halbleitergebiet (18, 38, 78) mittels Ionenimplantation hergestellt wird.

11. Verfahren nach mindestens einem der Ansprüche 8 bis 10, dadurch gekennzeichnet, daß die in verschiedenen isolierten Halbleiterbereichen hergestellten Gebietsanordnungen durch die sich an die Ausbildung der Dotierungsgebiete anschließenden weiteren Verfahrensschritte wahlweise je als Widerstands- und/oder Transistorstrukturen fertiggestellt werden.

## Claims

1. Semiconductor array for resistance structures in high density integrated circuits, comprising a silicon semi-conductor body (10, 12) wherein individual semiconductor regions isolated against each other to receive circuit components are delimited by dielectric barrier surrounding regions (14, 44, 70), further comprising a first region of a first conductivity type including contacts and representing the resistance structure at the surface of such a delimited semiconductor region, a second semiconductor region (18, 38, 78) of opposite conductivity being provided thereunder and being in electrical connection to said semiconductor surface through a third semiconductor region (20, 40, 80) of said second conductivity type, characterized in that said dielectric barrier surrounding regions (14, 44, 70) consist of a dielectric material, and that said second semiconductor region (18, 38, 78) is a buried region the doping rate of which is high with respect to said first semiconductor region.

2. Semiconductor array as in claim 1, characterized in that the dielectric barrier surrounding regions (14, 44, 70) comprise at least one external layer of thermally grown silicon oxide (f.e. 42 in Fig. 5).

3. Semiconductor array as in claims 1 or 2, characterized in that one of the highly doped contact regions (22) for the reistance structure is arranged laterally adjacent to the dielectric barrier surrounding region (14) in the first semiconductor region of the first conductivity type, and the third semiconductor region (20) for the surface connection of the buried second semiconductor region (18) is formed on the opposite side laterally adjacent to the dielectric barrier surrounding region (Figs. 3, 4).

4. Semiconductor array as in claims 1 or 2, characterized by the provision of a second resistance structure within a dielectric barrier surrounding region in the semiconductor material of the first conductivity type below the second semiconductor region (38), whose electrical connection to the semiconductor surface is performed through semiconducting material regions of the first conductivity type in lateral arrangement thereto (Fig. 5).

5. Semiconductor array as in claim 4, characterized in that one higher doped connecting region (48) each of said first conductivity type for the second resistance structure is arranged laterally adjacent on opposite sides of a dielectric barrier surrounding region (44).

6. Semiconductor array according to at least one of the previous claims, characterized in that the regions provided for in several isolated semiconductor regions can selectively be connected as resistance and/or transistor structures.

7. Semiconductor array as in claim 6, characterized in that the semiconductor regions for the first and second resistance structure represent the emitter and collector region and the intermediate buried second region the base region of a transistor structure (Figs. 9, 10).

8. Method of fabricating a semiconductor array according to at least one of the previous claims wherein isolated semiconductor regions to receive circuit components are delimited by dielectric barrier surrounding regions (14, 44, 70) in a silicon semiconductor body (10, 12), characterized by subsequent method steps:

— in a first semiconductor material region of a first conductivity, extending to the surface of the semiconductor body, the formation of a highly doped buried second semiconductor region (18, 38, 78) with an opposite second conductivity

— a third semiconductor region (20, 40, 80) of the second conductivity is provided at least on one side of the second buried semiconductor region to form the electrical connection of the semiconductor surface to the second semiconductor region

— connector regions or contacts respectively for the connection of external circuits are produced in the first and third semiconductor regions adjacent to the dielectric barrier surrounding regions.

9. A method according to claim 8, characterized in that the second semiconductor region including the laterally provided third semiconductor region that extends up to the semiconductor surface is formed in such a way that it encloses completely on the sides and downwards the first semiconductor region, and that the semiconductor material of the first conductivity remaining laterally and below the second and third semiconductor regions up to the surrounding regions is formed as a second buried resistance structure in the same isolated semiconductor region by the provision of doped regions of the same conductivity providing for the connection to the semiconductor surface.

10. Method according to claims 8 or 9, characterized in that especially the second semiconductor region (18, 38, 78) is produced by means of ion implantation.

11. Method according to at least one of the claims 8 to 10, characterized in that the regional arrays produced in the individual isolated semiconductor regions can selectively be finished as resistance and/or transistor structures in the method steps following the formation of the doped regions.

**Revendications**

1. Arrangement semi-conducteur pour des structures de résistances dans des circuits à haute densité d'intégration du genre comportant un substrat semi-conducteur de silicium (10, 12), dans lequel des régions diélectriques d'isolement (14, 44, 70) délimitent différentes régions semiconductrices isolées les unes des autres pour recevoir des éléments de circuit, comportant en outre une première région d'un premier type de conductivité comprenant des contacts et formant lune structure de résistance à la surface d'une desdites régions semi-conductrices ainsi délimitées, sous cette première région est disposée une seconde région semi-conductrice (18, 38, 78) du type de conductivité opposé et qui établit une connexion électrique avec la surface semi-conductrice à travers une troisième région semi-conductrice (20, 40, 80) du second type de conductivité, caractérisé en ce que les régions diélectriques d'isolement (14, 44, 70) sont des régions composées de matériaux diélectriques et que ladite seconde région semi-conductrice (18, 38, 78) est une région semiconductrice enterrée et fortement dopée par rapport à la première région.

2. Arrangement semi-conducteur selon la revendication 1, caractérisé en ce que les régions d'isolement diélectriques (14, 44, 70) comportent au moins une couche extérieure de dioxyde de silicium obtenue par croissance thermique (par exemple 42 sur la figure 5).

3. Arrangement semi-conducteur selon la revendication 1 ou 2, caractérisé en ce que l'une des régions de connexion fortement dopée (22) pour la structure de résistance est disposée de façon à être latéralement adjacente à la région d'isolement diélectrique (14) dans la première région semi-conductrice du premier type de conductivité et en ce que la troisième région semi-conductrice (20) est formée du côté opposé et latéralement adjacente à la région d'isolement diélectrique pour établir la connexion entre la surface et la seconde région semi-conductrice enterrée (18), (figures 3, 4).

4. Arrangement semi-conducteur selon la revendication 1 ou 2, caractérisé par une seconde structure de résistance prévue à l'intérieur d'une région semiconductrice délimitée dans le matériau semiconducteur du premier type de conductivité se trouvant en-dessous de la seconde région semi-conductrice (38) dont la connexion électrique avec la surface semi-conductrice est établie à travers des régions d'un matériau semi-conducteur du premier type de conductivité disposées latéralement par rapport à celles-ci (figure 5).

5. Arrangement semi-conducteur selon la revendication 4, caractérisé en ce que à chacun des côtés opposés d'une région d'isolement diélectrique (44) est disposée, latéralement adjacente, une région de connexion à dopage plus élevé (48) du premier type de conductivité pour la seconde structure de résistance.

6. Arrangement semi-conducteur selon au moins une des revendications précédentes, caractérisé en ce que les dispositions de région prévues dans les différentes régions semi-conductrices isolées peuvent être connectées sélectivement comme structures de résistance et/ou comme structures de transistor.

7. Arrangement semi-conducteur selon la revendication 6, caractérisé en ce que les régions semi-conductrices pour les première et seconde structures de résistance représentent les régions d'émetteur et de collecteur respectivement d'une structure de transistor, la seconde région enterrée intermédiaire formant la région de base (figures 9, 10).

8. Méthode pour fabriquer un arrangement semi-conducteur selon au moins l'une des revendications précédentes, caractérisée en ce que l'on délimite dans un substrat semi-conducteur de silicium (10, 12), à l'aide des régions d'isolement diélectriques (14, 44, 70), des régions semi-conductrices isolées pour recevoir des éléments de circuits, caractérisé par les étapes suivantes:

— formation dans une première région de matériau semi-conducteur du premier type de conductivité s'étendant jusqu'à la surface du substrat semi-conducteur d'une seconde région semi-conductrice enterrée (18, 38, 78) plus fortement dopée et du type de conductivité opposé,

— formation, au moins sur un côté de la seconde région semi-conductrice enterrée, d'une troisième région semi-conductrice (20, 40, 80) du second type de conductivité établissant une connexion électrique entre la surface semi-conductrice et la seconde région semi-conductrice, et

— formation, dans les première et troisième régions semi-conductrices, de régions de connexion ou de contact pour les connexions de circuits externes.

9. Procédé selon la revendication 8, caractérisé en ce que la seconde région semi-conductrice, y compris la troisième région semi-conductrice disposée latéralement et s'étendant jusqu'à la surface semi-conductrice, est formée de telle sorte qu'elle entoure complètement sur les côtés et vers le bas la première région semi-conductrice, et en ce que la matériau semi-conducteur du premier type de conductivité restant latéralement et en-dessous des seconde et troisième régions semi-conductrices jusqu'aux régions d'isolement forme une seconde structure de résistance enterrée dans la même région semi-conductrice isolée en prévoyant des régions dopées du même type de conductivité pour la connexion avec la surface semi-conductrice.

10. Procédé selon la revendication 8 ou 9, caractérisé en ce qu'en particulier la seconde région semi-conductrice (18, 38, 78) est obtenue par implantation ionique.

11. Procédé selon au moins l'une des revendications 8 à 10, caractérisé en ce que les régions disposées dans les différentes régions semi-conductrices isolées peuvent être sélectivement transformées en structures de résistance et/ou de transistor au cours des étapes qui suivent la formation des régions dopées.

FIG. 1

FIG. 2

FIG. 3

FIG. 4

1

**FIG. 5**

**FIG. 6**

**FIG. 7**

**FIG. 8**

**FIG. 10**

**FIG. 9**